# EUROPEAN PATENT SPECIFICATION

(11) **EP 2 266 146 B1**
(45) Date of publication and mention of the grant of the patent: **14.09.2011**
(21) Application number: 08873821.6
(22) Date of filing: 03.07.2008
(51) Int. Cl.: H01L 31/048

(54) **GLAZING ASSEMBLIES THAT INCORPORATE PHOTOVOLTAIC ELEMENTS AND RELATED METHODS OF MANUFACTURE**
GLASIERUNGSBAUGRUPPEN MIT PHOTOVOLTAIKELEMENTEN UND DIESBEZÜGLICHE HERSTELLUNGSVERFAHREN
ENSEMBLES DE VITRAGE QUI INCORPORENT DES ÉLÉMENTS PHOTOVOLTAÏQUES ET PROCÉDÉS DE FABRICATION APPARENTÉS

(30) Priority: 10.04.2008 US 43908 P
(43) Date of publication of application: 29.12.2010
(73) Proprietor: Cardinal IG Company, Eden Prairie, MN 55344-4235 (US)
(72) Inventor: O'SHAUGHNESSY, Roger, D., Wayzata MN 55391 (US); GROMMESH, Robert, C., St. LouisPark MN 55426 (US)
(74) Representative: Howe, Steven
(86) International application number: PCT/US2008/069175
(87) International publication number: WO 2009/126170

(56) References cited:
- EP-A- 1 020 930
- US-A- 5 128 181
- US-A1- 2002 153 038
- US-A1- 2008 041 434

## Description

### TECHNICAL FIELD

The present invention pertains to glazing assemblies, and the like, which incorporate photovoltaic elements.

### BACKGROUND

Insulating glass (IG) units are glazing assemblies that typically include at least a pair of panels, or substrates, joined together such that a major surface of one of the substrates faces a major surface of the other of the substrates, and an air space is enclosed between the two substrates. At least one of the substrates is transparent, or light transmitting, and may bear a coating on the major surface that faces the major surface of the other substrate. Document US2002/0153038 A discloses a glazing assembly containing a photovoltaic component.

With the recent renewed interest in harnessing solar power, and the associated development of photovoltaic coatings for solar power cells, various configurations of glazing assemblies that incorporate photovoltaic coatings, have been proposed. These glazing assemblies, when configured as IG units, may be more cost effective than traditional laminated solar panels, for example, in that a bulk of the material (e.g. EVA), which encapsulates the photovoltaic coating, in the traditional solar panel, is replaced with an air space, thereby reducing material cost and manufacturing time, per unit. Yet, there is still a need for improved configurations of glazing assemblies that effectively incorporate photovoltaic coatings, in order to generate solar power.

### BRIEF SUMMARY

The present invention relates to a glazing assembly as recited in claim 1, with preferred features specified in the dependent claims.

Embodiments of the present invention include photovoltaic panels, which are particularly suited for incorporation into IG unit - type glazing assemblies, as one of the substrates, and further include configurations of these glazing assembles, as well as associated methods of manufacture. These embodiments may incorporate one or more cost effective elements to enhance protection against degradation of the photovoltaic coatings thereof, for example, resulting from contact with moisture and/or with other components of the glazing assembly, and/or to lend additional structural integrity.

According to some preferred embodiments, a photovoltaic coating extends over, and is adhered to, a central region of an inner major surface of a first substrate of a glazing assembly, and a flexible and electrically non-conductive film extends over approximately an entirety of the photovoltaic coating, such that the photovoltaic coating is sandwiched between the film and the first substrate; the glazing assembly further includes a second substrate which is joined to the first substrate, along corresponding peripheral regions thereof, by a seal member, such that an air space is located between an exposed surface the film and the second substrate. The film may be pre-formed, for example, from a polyethylene, a polypropylene or a polyester material, and may have a thickness between approximately 0.001 inch and approximately 0.015 inch. According to further embodiments, the first substrate, the photovoltaic coating and the film may initially be assembled into a photovoltaic panel, having the aforementioned configuration, for subsequent incorporation into the glazing assembly, by joining the peripheral region of another substrate to the peripheral region of the first substrate, which is essentially free of the coating and the film. Prior to joining the other substrate of the glazing assembly to the photovoltaic panel, a desiccant material may be adhered to the exposed surface of the film.

### BRIEF DESCRIPTION OF THE DRAWINGS

The following drawings are illustrative of particular embodiments of the present invention and therefore do not limit the scope of the invention. The drawings are not to scale (unless so stated) and are intended for use in conjunction with the explanations in the following detailed description. Embodiments of the present invention will hereinafter be described in conjunction with the appended drawings, wherein like numerals denote like elements.

Figure 1 is a perspective view of a glazing assembly, according to some embodiments of the present invention.

Figure 2 is a schematic plan view of either of the substrates of the assembly shown in Figure 1.

Figure 3 is a perspective view of a portion of the assembly shown in Figure 1.

Figure 4 is a section view through section line A-A of Figure 1, according to some embodiments.

Figure 5 is a cross-section of a portion of the assembly shown in Figure 4, according to one embodiment.

Figure 6 is a flow chart outlining some assembly methods of the present invention.

### DETAILED DESCRIPTION

The following detailed description is exemplary in nature and is not intended to limit the scope, applicability, or configuration of the invention in any way. Rather, the following description provides practical illustrations for implementing exemplary embodiments of the present invention.

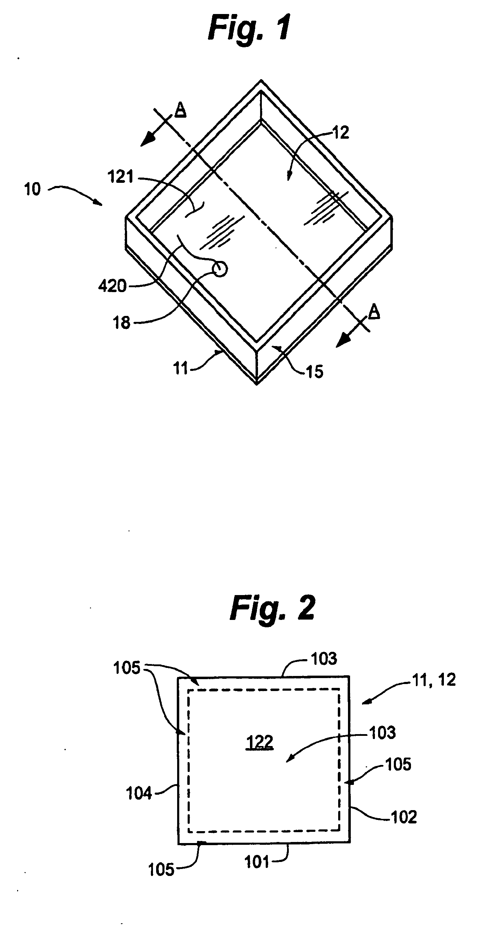

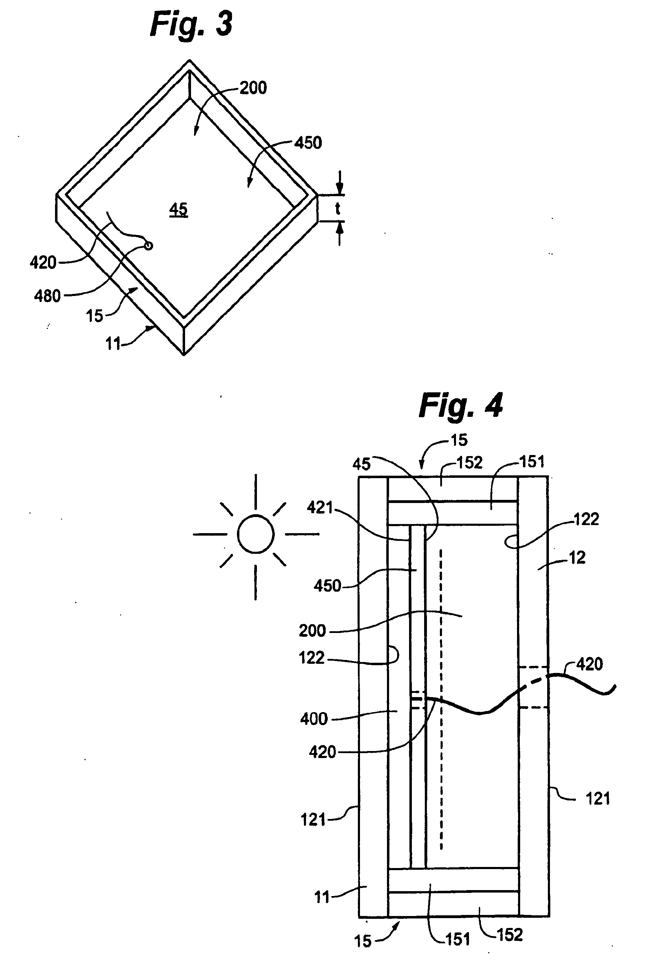

Figure 1 is a perspective view of a glazing assembly 10, according to some embodiments of the present invention. Figure 1 illustrates assembly 10 including a first substrate 11, a second substrate 12 and a seal system 15, which joins substrates 11, 12 together; a first major surface 121 of each of substrates 11, 12, face outward or away from one another, and a second major surface 122 of each of substrates 11, 12 faces inward, or toward one another, being spaced apart from one another by a seal system 15. Figure 2 is a schematic plan view of either of the substrates 11; 12 of assembly 10. Figure 2 illustrates second, or inner major surface, 122 of substrate 11/12 having a central region 103 and a peripheral region 105, which are delineated from one another by the dashed line. According to the illustrated embodiment, seal system 15 joins first substrate 11 to second substrate 12 along peripheral regions 105 of inner major surfaces 122. Figure 3 is a perspective view of assembly 10, having second substrate 12 removed to show an air space 200 that is enclosed between substrates 11, 12 when they are joined together by seal system 15.

Figure 3 further illustrates seal system 15 having a thickness t, which, according to some embodiments, is between aproximately about 0.25 mm (0.01 inch) and approximately about 2.5 mm (0.1 inch), preferably approximately 1 mm (0.04 inch),but could be up to 1.5 inches in alternate embodiments. According to some embodiments, seal system 15 is formed, at least in part, from a polymer material, for example, a thermoplastic, such as a Kommerling TPS, having low moisture vapor transmission properties, for example, resulting in a moisture vapor transmission rate (MVTR) therethrough, which does not exceed approximately 20 g mm/m²/day. Other examples of these polymer materials include, without limitation, butyl rubber, ionomers, ethylene methacrylic acid copolymers and polyisobutylenes, the ethylene methacrylic acid copolymers being preferred for their excellent adhesion properties, which are desirable to hold together glazing assemblies such as assembly 10. Some examples of these preferred materials, which are commercially available, are Sentry Glas®Plus, available from DuPont, and PRIMACOR™, available from Dow Chemical. According to some alternate embodiments, seal system 15 includes a first seat member 151, which extends about an inner portion of peripheral region 105. and a second seal member 152, which extends about an outer portion of perimeter region 105, for example as illustrated in Figure 4.

Figure 4 is a section view through section line A-A of Figure 1. With reference to Figure 4, first seal member 151 may be affixed to opposing peripheral regions 105 of inner major surfaces 122 of substrates 11, 12, in order to join substrates 11, 12 to one another, leaving an outer perimeter channel between the outer portions of the opposing peripheral regions 105 to be later filled with second seal member 152, First seal member 151 is preferably formed from a polymer material, which has low moisture vapor transmission properties, for example, any of those referenced above; and second seal member 152 may be formed of any material having suitable adhesive properties, for example, silicone, polysulfide or polyurethane.

According to some preferred embodiments, first substrate 11 is light transmitting, for example, formed from glass or a plastic material, such as polycarbonate, and second substrate 12 may be similarly formed or maybe opaque. According to some alternate embodiments, second substrate is light transmitting, for example, formed from glass or a plastic material, such as polycarbonate, and first substrate 11 may be similarly formed or may be opaque. Although the term "glazing" typically connotes incorporation of a glass panel or substrate, the use of the term is not so limited in the present disclosure, and glazing assemblies of the present invention may incorporate any light transmitting substrate, for example, formed from a plastic such as polycarbonate. Figure 4 further illustrates glazing assembly 10 including a photovoltaic coating 400 extending over, and being adhered to, inner major surface 122 of first substrate 11, and a flexible and electrically non-conductive film 450 extending over photovoltaic coating 400, such that coating 400 is sandwiched between substrate 11 and film 450, and airspace 200 is located between an exposed surface 45 of film and second substrate 12.

Film 450 may be pre-formed prior to application over coating 400, from a polyolefin material, for example, a polyethylene or polypropylene, or from a polyester material, and has a thickness between approximately about 0.025 mm (0.001 inch) and approximately about 0.038 mm (0.015 inch), preferably approximately 0.059 mm (0.0035 inch). According to some preferred embodiments, film 450, when pre-formed, includes an adhesive backing 421 for adhering film 450 to coating 400, and may be supplied in rolls. Adhesive backing 421 may be formed by an acrylic adhesive or by a rubber-based adhesive, or by any other suitable adhesive known to those skilled in the art, and may extend over approximately an entirety of the interface between-film 450. and coating 400 or just over selected portions of the interface

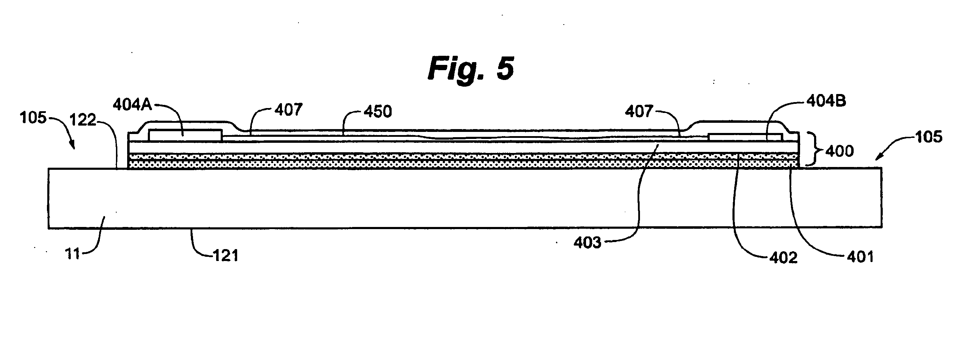

According to embodiments of the present invention, substrate 11, photovoltaic coating 400 and flexible and electrically non-conductive film 450 form a photovoltaic panel of assembly 10 so that assembly 10 can function as a solar power cell. Photovoltaic coating 400 may be of any type known to those skilled in the art, either of the conventional type, for example, including an array of silicon wafers interconnected by soldered conductors, or of the 'thin film' type, for example, including several thin film semiconductor layers, which are patterned to form electrically interconnected cells. An embodiment of the present invention, which includes coating 400 as a thin film CdTe type is described in conjunction with Figure 5, however, it should be appreciated that alternate embodiments may incorporate coating 400 as a thin film Cu(InGa)Se₂ (CIGS) type or amorphous silicon(a-Si) type.

Because film 450 is enclosed between first and second substrates 11, 12 of glazing assembly 10, film 450 need not have a durability that is otherwise required for exposed polymer back skins employed by some photovoltaic panels known in the art. However, according to some preferred embodiments, film 450 has properties such that the integrity of film 450 is maintained under thermal cycling conditions, for example, temperatures ranging between approximately - 40°C and approximately 85°C, over a life span of up to, and preferably exceeding, approximately 20 years.

With further reference to Figure 4, a dotted line schematically represents an optional desiccant material enclosed within airspace 200 to absorb any moisture that may pass through seal system 15. The desiccant material, either in sheet or strip form, or granular form, either embedded in a matrix or packaged in a sack, may be 'free-floating' in airspace 200, or adhered to exposed surface 45 of film 450 or to second substrate 12, or otherwise present in airspace 200. The desiccant material, in combination with the aforementioned relatively-low MVTR of seal system 15, may prevent moisture build-up within airspace 200 that can lead to corrosion of certain elements of photovoltaic coating 400. According to some embodiments, a plurality of desiccant beads are adhered to a surface of a sheet-like material, or tape, which is then adhered to exposed surface 45 of film 450.

Figure 5 is a cross-section of the photovoltaic panel portion of the assembly shown in Figure 4. Figure 5 illustrates coating 400 including a first layer 401 formed by a transparent conductive oxide (TCO), for example, comprising Tin oxide (SnO₂) which is overlaid with a semiconductor layer 402, for example, comprising two 'sub-layers': Cadmium sulfide (CdS; 'window' layer; n-type), extending adjacent to first layer 401, and Cadmium Telluride (CdTe; absorbing layer; p-type), overlaying the Cadmium sulfide sub-layer. Figure 5 further illustrates an electrical contact layer 403, for example, comprising nickel, which extends between the Cadmium Telluride sub-layer of semiconductor layer 402, and a pair of bus bars 404A, 404B. Bus bars 404A, 4048 may each be formed from a copper tape, for example, approximately about 0.076 to 0.178mm (0.003 - 0.007 inch) thick, which are adhered to contact layer 403, for example, by a conductive acrylic adhesive. Bus bars 404A, 404B preferably extend approximately parallel to one another along opposing edge portions of coating 400; an internal insulated conductor 407 is coupled to each bus bar 404A, 404B, and conductors 407 terminate near an electrical access opening 480 in film 450 (Figure 3). Film 450 can provide additional retention for holding bus bars 404A, 404B in intimate contact with contact layer 403 and for securing insulated conductors 407 against layer 400. An electrical lead 420, which is shown in Figures 1, 3 and 4, includes a pair of isolated conductive lead wires to collect power from the photovoltaic panel; each lead wire is coupled to a corresponding conductor 407, for example, via soldering to a respective terminal thereof in proximity to opening 480.

With reference to Figure 1, second substrate12 is shown including an opening 18, which is approximately aligned with electrical access opening 480, ant extends through second substrate 12, to allow further passage of lead 420 out from assembly 10. A diameter of openings 480, 18 may be between approximately about 6 mm (1/4 inch) and approximately about 25 mm (1 inch). According to the illustrated embodiment, after routing lead 420 out from system 10, through opening 18, a potting material is applied around lead 420, to seal off opening 18. Examples of suitable potting materials include, without limitation, polyurethane, epoxy, polyisobutylene, and any low MVTR material. According to alternate embodiments, one or both of openings 480, 18 are not necessary and lead 420 extends out from assembly 10 through an opening in seal system 15 or through an opening between seal system 15 and one of substrates 11, 12, or through an opening in first substrate 11.

According to some preferred embodiments of the present invention, the flexibility of film 450, in combination with a tear strength thereof, is suited to hold substrate 11 and photovoltaic coating 400 together in case substrate 11 is fractured, thereby containing fragments of the fractured substrate 11 to prevent a scattering of potentially toxic elements of photovoltaic coating 400, for example, Cadmium. Furthermore, in the event that substrate 12 is broken, the electrical insulating properties of film 450 preferably electrically isolates coating 400 and electrically charged conductors 407, which are coupled to bus bars 404A,B of coating 400, thereby preventing potential injury to one handling the broken assembly. Film 450 may further protect the semiconductor sub-layers of coating 400 if, during relatively cold temperature conditions, the air space between substrates 11, 12 shrinks such that substrates 11, 12 come into contact. According to some embodiments, in which sun light is received by coating 400 through first substrate 11, for example, in the case of the CdTe type of coating (Figure 5), and second substrate 12 is translucent or transparent, flexible film 450 is opaque to provide a more aesthetically pleasing uniform appearance to the photovoltaic panel, when viewed through second substrate 12. According to those embodiments in which coating 400 is the CIGS type, since sun light is received by the coating 400 through second substrate 12 and through film 450, film 450 needs to light transmitting.

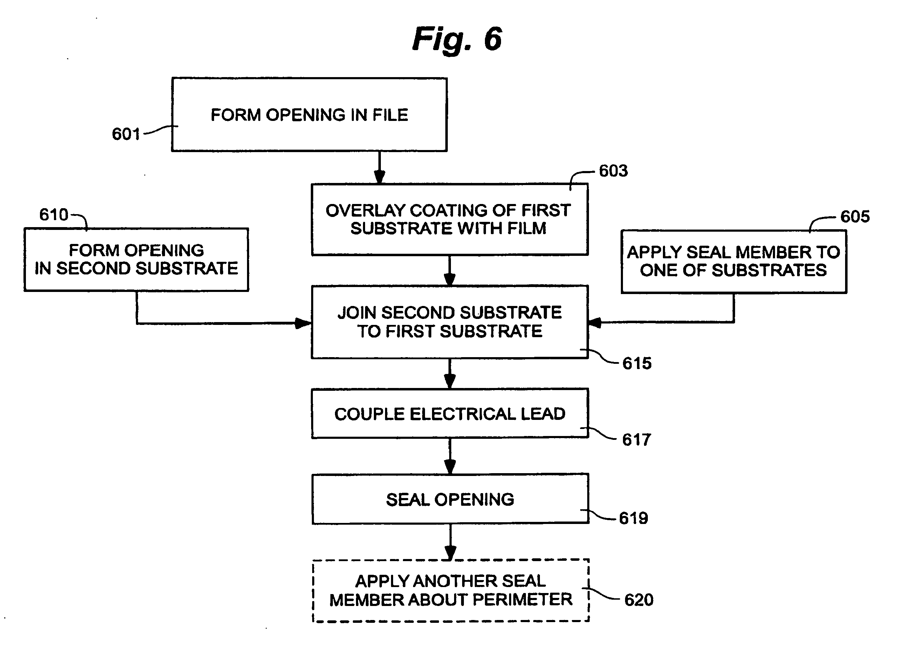

Figure 6 is a flow chart outlining some assembly methods that can be used in the formation of a glazing assembly of the present invention, which start with a first substrate, for example, first substrate 11, that has a photovoltaic coating, for example, coating 400 (Figure 4), already formed over a central region of a major surface thereof, for example, central region 103 of surface 122 (Figure 2). This pre-formed photovoltaic coating preferably extends over the central region of the major surface of the first substrate, without significantly encroaching on a peripheral region of the surface, for example, region 105 (Figures 2 and 5), so as to maintain exposure of a native surface of the substrate for fixation to a sealing member, for example, included in sealing system 15, which joins the first substrate to an opposing second substrate, for example, second substrate 12. According to the outlined method, an opening is formed in a sheet of flexible and electrically non-conductive film, for example, electrical access opening 480 in film 450 (Figure 3), per step 601, and then the photovoltaic coating of the first substrate is overlaid with the film, per step 603. As previously described, the film is adhered to the photovoltaic coating, preferably by means of an adhesive backing pre-formed on a surface of the film. The overlaid film preferably covers an entirety of the photovoltaic coating, for example, as shown in Figure 5, while leaving enough of the peripheral region of the surface of the first substrate, for example region 105, free for fixation with a sealing member that will join the first substrate to the second substrate. However, according to some embodiments, the film may not cover a portion of a perimeter of the coating, which portion may extend between the sealing member and the first substrate.

According to the outlined method, following step 603, the seal member is applied to one of first and second substrates, per step 605, and then second substrate is joined to first substrate, per step 615. Joining the first substrate to the second substrate, per step 615, includes pressing the two substrates together, with the seal member sandwiched therebetween along the peripheral regions of the facing major surfaces, while maintaining an air space, for example air space 200 (Figure 4), between the central regions of the facing major surfaces; heat may be applied, along with pressure, to securely affix the seal member to each of the substrates. Prior to joining the second substrate to the first substrate, per step 615, an opening, for example, opening 18 (Figure 1), is formed in second substrate, per step 610, according to the outlined method. The opening in the second substrate is preferably aligned with the opening in the film when the second substrate is joined to the first substrate, per step 615.

After joining the second substrate to the first substrate, an external lead, for example, lead 420 (Figures 1, 3 and 4), is coupled, through the openings in the film and the second substrate, to internal conductors, for example, conductors 407 (Figure 5), which extend from the bus bars of the photovoltaic coating, per step 617, as previously described. According to step 619, a potting material is applied around the lead at the opening to seal of the opening, also as previously described; the potting material may further form a strain relief for the lead adjacent to the second substrate, or a separate strain relief member may be installed about the lead. Finally, if the aforementioned seal member, which joins the first substrate to the second substrate, is a first of a pair of seal members in a seal system, for example, seal system 15 illustrated in Figure 4, the second seal member, for example, seal member 152, is applied about a perimeter of the first seal member in between the first and second substrates, per optional step 620.

In the foregoing detailed description, the invention has been described with reference to specific embodiments. However, it may be appreciated that various modifications and changes can be made without departing from the scope of the invention as specified by the appended claims.

## Claims

1. A glazing assembly (10) comprising:
a first glass substrate (11) including an inner major surface (122), the inner major surface including a central region (103) and a peripheral region (105);
a photovoltaic coating (400) extending over, and being adhered to, the central region of the inner major surface of the first substrate (11);
a flexible and electrically non-conductive film (450) extending directly over approximately an entirety of the photovoltaic coating (400), such that the photovoltaic coating is sandwiched between the film (450) and the first substrate (11), the film (450) having a thickness of between about 25×10⁻⁶m and 380×10⁻⁶m (0.001 inch and 0.015 inch), wherein the film (450) is pre-formed and includes an adhesive backing adhering the film (450) to the photovoltaic coating (400);
a second glass substrate (12) opposing the first substrate (11) and including an inner major surface (122) which faces the inner major surface (122) of the first substrate (11) the inner major surface (122) of the second substrate (112) including a central region (103), approximately aligned with the central region (103) of the inner major surface (122) of the first substrate (11), and a peripheral region (105), approximately aligned with the peripheral region (105) of the inner major surface (122) of the first substrate (11) such that the inner major surfaces (122) of the first and second glass substrates (11,12) face toward each other and are spaced apart from each other by a seal system (15);
the seal system (15) joining the first substrate (11) to the second substrate (12) along the peripheral regions (105) of the inner major surfaces (122) thereof, such that an air space (200) is defined between the exposed surface of the film (450) and the second substrate (12) the seal system having a thickness t of between about 0.25mm and 2.5mm (0.01 inch and 0.1 inch), the seal system (15) being formed by a first seal member (115) that extends about an inner portion of said peripheral regions (105) of the first and second substrates (11,12) and a second seal member (152) that extends about an outer portion of said peripheral regions (105) of the first and second substrates (11,12), the second seal member (152) being positioned in an outer perimeter channel located between outer portions of said peripheral regions (105) of the first and second substrates (11,12).

2. The assembly of claim 1, wherein the film (450) comprises a material selected from the group consisting of: polyolefin, polyethylene, polypropylene and polyester.

3. The assembly of claim 1, wherein the film (450) is opaque.

4. The assembly of claim 1, wherein the film (450) includes an electrical access opening extending therethrough.

5. The assembly of claim 1, wherein the second substrate includes an opening (480) extending therethrough, the opening (480) being located in the central region (103) of the inner major surface (122) thereof.

6. The assembly of claim 1, wherein a width of the air space (200) between the first and second substrates is approximately about 1mm (0.04 inch).

7. The assembly of claim 1, further comprising a desiccant material adhered to the film (450) and located within the air space (200).

8. The assembly of claim 1, wherein a second major surface of each of said glass substrate (11, 12) faces outwardly of the assembly (10).

9. The assembly of claim 1, wherein the first seal member (115) is formed of a polymer and the second seal member (152) is formed of silicone, polysulfide, or polyurethane.

10. The assembly of claim 1, wherein the adhesive backing is formed of an acrylic or rubber-based material and is located at an interface between the film (450) and the photovoltaic coating (400).

11. The assembly of claim 1. wherein the film (450) has a flexibility and tear strength sufficient to hold the photovoltaic coating (400) and the first glass substrate (11) together in the event the first glass substrate (11) is fractured.

## Patentansprüche

1. Glasierungsbaugruppe (10), die Folgendes umfasst:
ein erstes Glassubstrat (11) mit einer inneren Hauptfläche (122), wobei die innere Hauptfläche eine zentrale Region (103) und eine periphere Region (105) aufweist;
eine fotovoltaische Beschichtung (400), die über die zentrale Region der inneren Hauptfläche des ersten Substrats (11) verläuft und daran haftet;
einen flexiblen und elektrisch nichtleitenden Film (450), der direkt über etwa die gesamte fotovoltaische Beschichtung (400) verläuft, so dass die fotovoltaische Beschichtung zwischen dem Film (450) und dem ersten Substrat (11) liegt, wobei der Film (450) eine Dicke zwischen etwa 25 x 10⁻⁶ m und 380 x 10⁻⁶ m (0, 001 Zoll und 0,015 Zoll) hat, wobei der Film (450) vorgeformt ist und eine klebrige Rückseite hat, mit der der Film (450) auf die fotovoltaische Beschichtung (400) geklebt ist;
ein zweites Glassubstrat (12), das dem ersten Substrat (11) gegenüber liegt und eine innere Hauptfläche (122) hat, die der inneren Hauptfläche (122) des ersten Substrats (11) zugewandt ist, wobei die innere Hauptfläche (122) des zweiten Substrats (12) eine zentrale Region (103), die etwa mit der zentralen Region (103) der inneren Hauptfläche (122) des ersten Substrats (11) fluchtet, und eine periphere Region (105) aufweist, die etwa mit der peripheren Region (105) der inneren Hauptfläche (122) des ersten Substrats (11) fluchtet, so dass die inneren Hauptflächen (122) des ersten und zweiten Glassubstrats (11, 12) einander zugewandt und durch ein Dichtungssystem (15) voneinander beabstandet sind;
wobei das Dichtungssystem (15) das erste Substrat (11) entlang der peripheren Regionen (105) der inneren Hauptflächen (122) davon an das zweite Substrat (12) fügen, so dass ein Luftraum (200) zwischen der exponierten Fläche des Films (450) und dem zweiten Substrat (12) definiert wird, wobei das Dichtungssystem eine Dicke t zwischen etwa 0,25 mm und 2,5 mm (0,01 Zoll und 0,1 Zoll) hat, wobei das Dichtungssystem (15) von einem ersten Dichtungselement (115) gebildet wird, das um einen inneren Abschnitt der genannten peripheren Regionen (105) des ersten und zweiten Substrats (11, 12) verläuft, und ein zweites Dichtungselement (152), das um einen äußeren Abschnitt der genannten peripheren Regionen (105) des ersten und zweiten Substrats (11, 12) verläuft, wobei das zweite Dichtungselement (152) in einem äußeren Umfangskanal positioniert ist, der sich zwischen äußeren Abschnitten der genannten peripheren Regionen (105) und dem ersten und zweiten Substrat (11, 12) befindet.

2. Baugruppe nach Anspruch 1, wobei der Film (450) ein Material umfasst, das ausgewählt ist aus der Gruppe bestehend aus Polyolefin, Polyethylen, Polypropylen und Polyester.

3. Baugruppe nach Anspruch 1, wobei der Film (450) opak ist.

4. Baugruppe nach Anspruch 1, wobei der Film (450) eine durch ihn verlaufende elektrische Zugangsöffnung aufweist.

5. Baugruppe nach Anspruch 1, wobei das zweite Substrat eine durch es verlaufende Öffnung (480) aufweist, wobei sich die Öffnung (480) in der zentralen Region (103) der inneren Hauptfläche (122) davon befindet.

6. Baugruppe nach Anspruch 1, wobei eine Breite des Luftraums (200) zwischen dem ersten und zweiten Substrat etwa 1 mm (0,04 Zoll) beträgt.

7. Baugruppe nach Anspruch 1, die ferner ein Trockenmittel umfasst, das an dem Film (450) haftet und sich in dem Luftraum (200) befindet.

8. Baugruppe nach Anspruch 1, wobei eine zweite Hauptfläche jedes der genannten Glassubstrate (11, 12) von der Baugruppe (10) nach außen gewandt ist.

9. Baugruppe nach Anspruch 1, wobei das erste Dichtungselement (115) aus einem Polymer gebildet ist und das zweite Dichtungselement (152) aus Silikon, Polysulfid oder Polyurethan gebildet ist.

10. Baugruppe nach Anspruch 1, wobei die klebrige Rückseite aus einem Material auf Acryl- oder Gummibasis gebildet ist und sich an einer Grenzfläche zwischen dem Film (450) und der fotovoltaischen Beschichtung (400) befindet.

11. Baugruppe nach Anspruch 1, wobei der Film (450) eine Flexibilität und Reißfestigkeit aufweist, die ausreichen, um die fotovoltaische Beschichtung (400) und das erste Glassubstrat (11) zusammenzuhalten, falls das erste Glassubstrat (11) bricht.

## Revendications

1. Ensemble de vitrage (10) comprenant :
un premier substrat en verre (11) incluant une surface interne majeure (122), la surface interne majeure incluant une région centrale (103) et une région périphérique (105);
un revêtement photovoltaïque (400) s'étendant sur et étant collé à la région centrale de la surface interne majeure du premier substrat (11);
un film flexible électriquement non conducteur (450) s'étendant directement sur une intégralité du revêtement photovoltaïque (400), de sorte que le revêtement photovoltaïque est en sandwich entre le film (450) et le premier substrat (11), le film (450) ayant une épaisseur d'entre environ 25 x 10⁻⁶ m et 380 x 10⁻⁶ m (0,001 pouce et 0,015 pouce), dans lequel le film (450) est préformé et comprend une couche dorsale adhésive collant le film (450) au revêtement photovoltaïque (400);
un deuxième substrat en verre (12) à l'opposé du premier substrat (11) et incluant une surface interne majeure (122) qui fait face à la surface interne majeure (122) du premier substrat (11), la surface interne majeure (122) du deuxième substrat (12) incluant une région centrale (103) approximativement alignée avec la région centrale (103) de la surface interne majeure (122) du premier substrat (11) et une région périphérique (105) approximativement alignée avec la région périphérique (105) de la surface interne majeure (122) du premier substrat (11) de sorte que les surfaces internes (122) des premier et deuxième substrats en verre (11, 12) se font face l'une à l'autre et sont espacées l'une de l'autre par un système d'étanchéité (15);
le système d'étanchéité (15) raccordant le premier substrat (11) au deuxième substrat (12) le long des régions périphériques (105) des surfaces internes majeures (122) de ceux-ci, de sorte qu'un espace d'air (200) est défini entre la surface exposée du film (450) et le deuxième substrat (12), le système d'étanchéité ayant une épaisseur d'entre environ 0,25 mm et 2,5 mm (0,01 pouce et 0,1 pouce), le système d'étanchéité (15) étant formé par un premier membre d'étanchéité (115) qui s'étend autour d'une portion interne desdites régions périphériques (105) des premier et deuxième substrats (11, 12) et un deuxième membre d'étanchéité (152) qui s'étend autour d'une portion externe desdites régions périphériques (105) des premier et deuxième substrats (11, 12), le deuxième membre d'étanchéité (152) étant positionné dans un canal d'un périmètre extérieur situé entre des portions internes desdites régions périphériques (105) des premier et deuxième substrats (11, 12).

2. Ensemble selon la revendication 1, dans lequel le film (450) comprend un matériau sélectionné parmi le groupe consistant en : polyoléfine, polyéthylène, polypropylène et polyester.

3. Ensemble selon la revendication 1, dans lequel le film (450) est opaque.

4. Ensemble selon la revendication 1, dans lequel le film (450) comprend une ouverture électrique d'accès s'étendant à travers celui-ci.

5. Ensemble selon la revendication 1, dans lequel le deuxième substrat comprend une ouverture (480) s'étendant à travers celui-ci, l'ouverture (480) étant située dans la région centrale (103) de la surface interne majeure (122) de celui-ci.

6. Ensemble selon la revendication 1, dans lequel une largeur de l'espace d'air (200) entre les premier et deuxième substrats fait environ 1 mm (0.04 pouce).

7. Ensemble selon la revendication 1, comprenant en outre une substance déshydratante collée au film (450) et située dans l'espace d'air (200).

8. Ensemble selon la revendication 1, dans lequel une deuxième surface majeure de chacun desdits substrats en verre (11, 12) fait face à l'extérieur de l'ensemble (10).

9. Ensemble selon la revendication 1, dans lequel le premier membre d'étanchéité (115) est formé en un polymère et le deuxième membre d'étanchéité (152) est formé en silicone, polysulfure ou polyuréthane.

10. Ensemble selon la revendication 1, dans lequel la couche dorsale adhésive est formée en une matière acrylique ou à base de caoutchouc et est située à une interface entre le film (450) et le revêtement photovoltaïque (400).

11. Ensemble selon la revendication 1, dans lequel le film (450) a une flexibilité et une résistance à la rupture suffisantes pour tenir le revêtement photovoltaïque (400) et le premier substrat en verre (11) ensemble au cas où le premier substrat en verre (11) serait cassé.
